Europäisches Patentamt

European Patent Office

Office européen des brevets

(19)

(11) Veröffentlichungsnummer: **0 270 066**
**A2**

(12) # EUROPÄISCHE PATENTANMELDUNG

(21) Anmeldenummer: 87117723.4

(51) Int. Cl.⁴: **H05K 1/05**

(22) Anmeldetag: 01.12.87

(30) Priorität: 03.12.86 DE 3641202

(43) Veröffentlichungstag der Anmeldung:
08.06.88 Patentblatt 88/23

(84) Benannte Vertragsstaaten:
AT BE CH DE ES FR GB IT LI NL SE

(71) Anmelder: **Standard Elektrik Lorenz**
**Aktiengesellschaft**
**Lorenzstrasse 10**
**D-7000 Stuttgart 40(DE)**

(84) **DE**

(71) Anmelder: **Alcatel N.V.**
**Strawinskylaan 537 (World Trade Center)**
**NL-1077 XX Amsterdam(NL)**

(84) **BE CH ES FR GB IT LI NL SE AT**

(72) Erfinder: **Smernos, Stauros**
**Birkenwaldstrasse 127**
**D-7000 Stuttgart 1(DE)**
Erfinder: **Florjancic, Matjaz**
**Staffelseeweg 3**
**D-7000 Stuttgart 50(DE)**
Erfinder: **Richter, Horst**
**Tiergartenstrasse 29**
**D-7030 Böblingen(DE)**
Erfinder: **Ruess, Karin**
**Bussenstrasse 27**
**D-7000 Stuttgart 1(DE)**
Erfinder: **Bangert, Adolf**
**Beethovenstrasse 35**
**D-7530 Pforzheim(DE)**
Erfinder: **Szabo, Lazlo, Dr.**
**Tubitzer Strasse 11**
**D-7015 Korntal-Münchingen(DE)**
Erfinder: **Flocken, Reiner**
**Römerstrasse 31/1**
**D-7235 Renningen(DE)**

(74) Vertreter: **Beck-Seyffer, Karl Heinz, Dipl.-Ing.**
**et al**
**Standard Elektrik Lorenz AG Patent- und**
**Lizenzwesen Postfach 30 09 29**
**D-7000 Stuttgart 30(DE)**

(54) Metallkernleiterplatte als Träger für HF- und Mikrowellenschaltkreise.

(57) Es wird der Aufbau für eine Leiterplatte angegeben, die sich speziell als Träger für HF-und Mikrowellen-stromkreise eignet. Auf einem aus gut leitendem Material bestehenden oder mit gut leitendem Material (2) be-

schichteten Metallkern (1) ist eine gleichmäßige Schicht aus homogenem glasigem Email (3) aufgetragen. Darauf sind Leiterbahnen (4) aus Kupfer stromlos abgeschieden. Für die auf einem solchen Substrat ausgelegten HF- und Mikrowellenstromkreise lassen sich Dämpfungswerte und Resonanzgüten nachweisen, die Werten, die auf heute gebräuchlichen Substraten (Oxydkeramik, Polytetrafluorethylen) aufgebaute Schaltungen erbringen, zumindest gleichkommen.

Fig.1

## Metallkernleiterplatte als Träger für HF-und Mikrowellenschaltkreise

Die Erfindung betrifft eine Leiterplatte nach dem Oberbegriff des Patentanspruchs 1.

Solche Leiterplatten sind seit einigen Jahren bekannt und z.B in der US-PS 4 355 114 beschrieben. Sie haben sowohl gegenüber Leiterplatten aus organischen Werkstoffen als auch gegenüber rein keramischen Leiterplattensubstraten - beide werden heute in großem Umfang eingesetzt - Vorteile. Gegenüber den aus organischen Werkstoffen bestehenden Leiterplatten weisen sie größere Hitzebeständigkeit, größere Maßhaltigkeit, größere mechanische Stabilität und größeres Wärmeableitvermögen auf, keramischen Substraten sind sie an mechanischer Stabilität und an Wärmeableitvermögen überlegen.

Für HF-und Mikrowellenanwendungen wird eine geringe elektromagnetische Dämpfung angestrebt.

Zum Aufbau von HF-und Mikrowellenschaltkreisen werden bisher vor allem Substrate aus Oxydkeramik oder Polytetrafluoräthylen (PTFE) eingesetzt. Aufgrund ihrer geringen mechanischen Stabilität können Substrate aus Oxydkeramik oder PTFE aber nicht in beliebiger Größe hergestellt werden. Außerdem können bei HF-und Mikrowellenanwendungen von solchen Substraten nicht beide Seiten für verschiedene, voneinander unabhängige Schaltungen genutzt werden, da im HF-und Mikrowellenbereich die einander nur durch das Dielektrikum getrennten, auf verschiedenden Seiten des Substrates angebrachten Leiterzüge elektrisch eine Einheit bilden (Streifenleitung). Es kann in der Regel nur immer eine Seite des Substrates mit einer Leiterstruktur versehen werden, während die andere Seite frei bleibt oder eine durchgehende Metallschicht trägt.

Es wurden auch Versuche unternommen, emaillierte Stahlsubstrate als Träger für HF-und Mikrowellenschaltungen zu verwenden. So wird in einem Aufsatz von A.Schwarzmann in "Proceedings of the ECC", 1979, Seite 132, über Mikrowellenstromkreise berichtet, die auf einseitig emaillierten kupferplattierten Stahlsubstraten mittels Dickfilmtechnik aufgebracht wurden. Bei diesen Stromkreisen wurden neben vielen Vorteilen auch Nachteile festgestellt, wie z.B. auf die begrenzte Dicke des Dielektrikums zurückzuführende hohe Verluste und auf die ungleichmäßige Dicke der Emailschicht zurückzuführende Schwierigkeiten bei der genauen Auslegung der Stromkreise.

Es ist Aufgabe der Erfindung, eine Metallkern-Leiterplatte der eingangs beschriebenen Art zu schaffen, die so ausgebildet ist, daß auf ihr aufgebrachte Leiterstrukturen im HF-und Mikrowellenbereich eingesetzt werden können und Dämpfungsverluste aufweisen, die erheblich unter denen der beschriebenen Mikrowellenstromkreise liegen.

Diese Aufgabe wird durch die im kennzeichnenden Teil des Patentanspruchs 1 angegebenen Merkmale gelöst.

Die für HF-und Mikrowellen geeigneten Metallkern-Leiterplatten nach der Erfindung weisen sehr günstige und optimierbare Werte für die Dielektrizitätskonstante und außerdem niedrige Dämpfungsverluste auf. Infolge der höheren mechanischen Stabilität der Metallkern-Leiterplatte können größere Substrate mit einer größeren Zahl von Stromkreisen geschaffen werden, als dies auf Basis von Oxydkermamik oder PTFE möglich war. Infolge der Schirmungswirkung des Metallkerns entfällt ein großer Teil der bisher notwendigen, auf den Substraten selbst oder in der Umgebung angeordneten Schirmungsflächen und es wird durch den Metallkern eine weitgehende gegenseitige Abschirmung der beiden Seiten der Leiterplatte bewirkt, so daß beide Seiten der Leiterplatte zum Aufbau voneinander getrennter Schaltkreise benutzt werden können, mithin eine Doppelplatine geschaffen werden kann.

Der Hauptnachteil bisher bekannter Metallkern-Leiterplatten, die hohen Dämpfungsverluste, konnten durch den Ersatz der Dickfilmleiterzüge durch leitfähigere Kupferleiterzüge erheblich reduziert werden. Die erforderliche Haftfestigkeit des Kupfers auf der Emailschicht wird dabei durch die Wahl eines sehr homogenen, glasigen Emails erreicht, welches sich nach einem Ätzvorgang zur Erzeugung einer Mikrorauhigkeit der Oberfläche stromlos verkupfern läßt.

Zweckmäßige Ausgestaltungen der erfindungsgemäßen Leiterplatte können den Unteransprüchen entnommen werden.

Anhand zweier Figuren soll nun ein Ausführungsbeispiel der Leiterplatte nach der Erfindung ausführlich beschrieben werden.

Fig. 1 zeigt den Schichtaufbau einer Leiterplatte nach der Erfindung;

Fig. 2 zeigt eine Leiterplatte mit einer UHF-Schaltung.

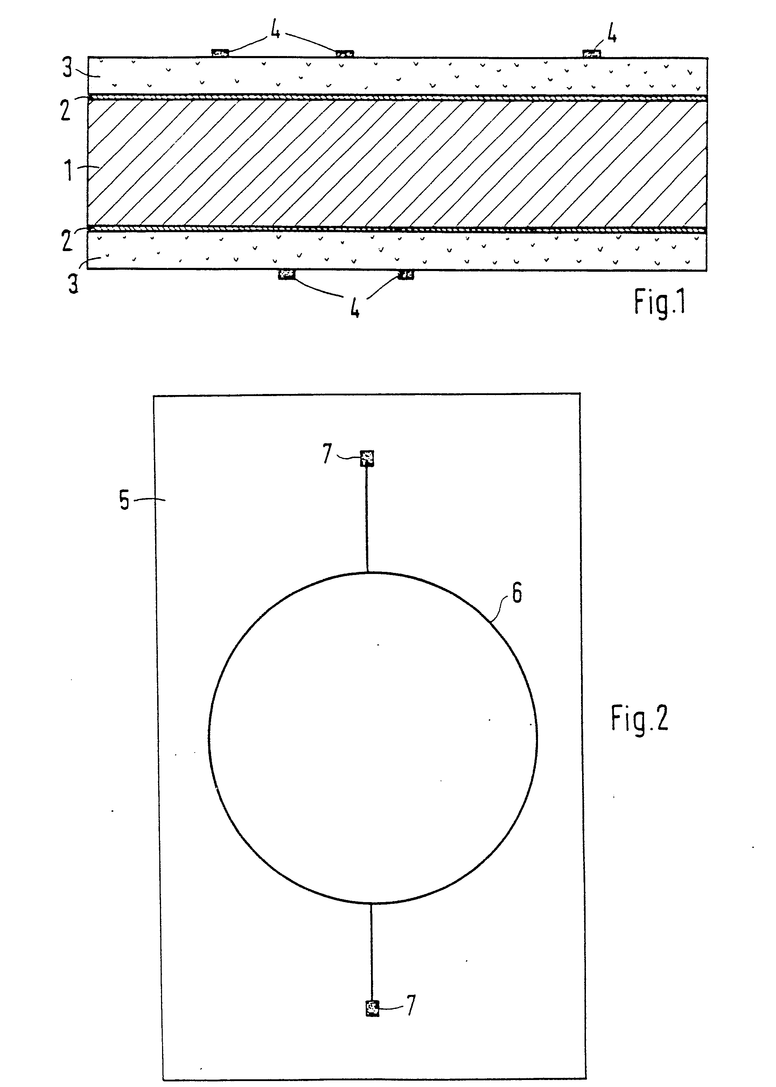

In Fig. 1 ist eine Metallkern-Leiterplatte mit einem Kern 1 aus einem weniger gut elektrisch leitenden Material, z.B. Stahl dargestellt, der auf der Ober-und Unterseite Auflagen 2 aus sehr gut leitendem Material, z.B. Kupfer, aufweist. Der derart beschichtete Kern ist mit einer glasigen oder keramischen Isolierschicht 3 überzogen, auf der sich Leiterbahnen 4 befinden. Da für UHF-Anwendungen eine ausgezeichnete Konstanz der Schichtdicke der Isolierschicht erforderlich ist, muß diese entweder nach dem Einbrennen plangeschliffen werden oder es muß zum Aufbringen der Isolierschicht ein Verfahren angewandt werden, das, wie z.B. ein elektrophoretischer Schichtenauftrag, einen sehr gleichmäßigen Aufbau der Schicht gestattet. Die Breite der Leiterbahnen innerhalb einer Leiterstruktur steht in einem bestimmten Verhältnis zur Dicke der Isolierschicht. Dieses Verhältnis hängt von der Arbeitsfrequenz der UHF-Schaltung ab und ist zweckmäßig 1 : 2. Es kann mittels der bekannten Wheeler-Formel (siehe z.B. Hoffmann: "Integrierte Mikrowellenschaltungen", Springer Verlag, 1983. Seite 152) für den gewünschten Wellenwiderstand bei bekannten Werten $\mu_r$ und $\varepsilon_r$ der Ausgangswerkstoffe und vorgegebener Leiterdicke ermittelt werden.

$$Z_0 [\Omega] = \frac{87 \sqrt{\mu_r}}{\sqrt{\varepsilon_r + 1,41}} \cdot \ln \frac{5,98 \ h}{0,8 \ w + t}$$

$Z_0$ = Wellenwiderstand des Leiters
$\mu_r$ = magnetische Permeabilität des Kerns
$\varepsilon_r$ = relative Dielektrizitätskonstante der Isolierschicht
h = Dicke der Isolierschicht
t = Dicke des Leiters
w = Breite des Leiters

In Fig. 2 ist ein Ringresonator mit 50 $\Omega$ Wellenwiderstand in natürlicher Größe wiedergegeben, der für eine Frequenz von 1 GHZ ausgelegt ist. Die auf einer Leiterplatte 5 zwischen Anschlußfeldern 7 angeordneten Leiterbahnen 6 weisen eine konstante, auf die Dicke und die Dielektrizitätskonstante der Isolierschicht abgestimmte Breite auf. Für diese und ähnliche Schaltungen lassen sich Dämpfungswerte und Resonanzgüten erreichen, welche den Werten, die auf heute gebräuchlichen Substraten aufgebaute Schaltungen erbringen, gleichkommen oder sie sogar übertreffen. Bei Verwendung von kupferbeschichteten Metallplatten als Leiterplattenkern ist darauf zu achten, daß die Kupferbeschichtung eine von der verwendeten Frequenz und der zugehörigen Eindringtiefe des elektromagnetischen Feldes abhängige Mindestdicke nicht unterschreitet.

In nachfolgender Tabelle sind Vergleichswerte für Dämpfungen von 50 $\Omega$-Leitungen dargestellt.

| Substrat | $\varepsilon_r$ | Substrat-dicke | Beschichtung, Leiterbahndicke | Dämpfung bei 2,4 GHZ | $\alpha$ dB/cm bei 1,5 GHZ | bei 1 GHZ |
|---|---|---|---|---|---|---|
| $Al_2O_3$ | 9,8 | 0,64 | 4,4$\mu$ Au | 0,03 | 0,022 | 0,02 |
| $Al_2O_3$ | 9,8 | 0,64 | 6,5$\mu$ Cu+2$\mu$ Au | 0,028 | 0,024 | 0,02 |
| PTFE-Material | 10,5 | 0,64 | 17$\mu$ Cu | 0,05 | 0,038 | 0,033 |
| Metall-kern-Leiter-platte | 7,2 | 0,3 | 17$\mu$ Cu | 0,059 | 0,035 | 0,028 |

4

## Ansprüche

1. Leiterplatte, bestehend aus einem metallischen, zumindest im Bereich seiner Oberfläche aus elektrisch besonders gut leitendem Werkstoff bestehenden Kern, einer auf diesem eingebrannten isolierenden Emailschicht und einer auf der Emailschicht aufgebrachten Leiterstruktur, **dadurch gekennzeichnet**, daß die Emailschicht (3) eine glasige, homogene Struktur mit sehr glatter Oberfläche aufweist und die Leiterstruktur (4) aus nach Anätzen und anschließender Bekeimung der Oberfläche auf diese stromlos aufgebrachtem Kupfer besteht.

2. Leiterplatte nach Anspruch 1, dadurch gekennzeichnet, daß der Kern von einer massiven Kupferplatte gebildet wird.

3. Leiterplatte nach Anspruch 1, dadurch gekennzeichnet, daß der Kern von einer beidseitig mit Kupfer beschichteten Metallplatte gebildet wird.

4. Leiterplatte nach einem der vorstehenden Ansprüche, dadurch gekennzeichnet, daß das Anätzen mittels Fluor-Ionen enthaltender Agenzien und die Bekeimung mittels eines Palladium-Aktivators vorgenommen wird.

0 270 066

Fig.1

Fig.2

S.Smernos·22·5·7
30·3·87